Europäisches Patentamt

European Patent Office

Office européen des brevets

(11) Publication number:

0 374 689
A2

## (12) EUROPEAN PATENT APPLICATION

(21) Application number: 89122897.5

(51) Int. Cl.5: H01L 39/24

(22) Date of filing: 12.12.89

(30) Priority: 22.12.88 US 288666

(43) Date of publication of application:
27.06.90 Bulletin 90/26

(84) Designated Contracting States:
DE FR GB NL

(71) Applicant: GENERAL ELECTRIC COMPANY
1 River Road
Schenectady, NY 12345(US)

(72) Inventor: Bray, James William
1513 Huntridge Drive
Clifton Park New York 12065(US)

(74) Representative: Schüler, Horst, Dr. et al
Kaiserstrasse 69
D-6000 Frankfurt/Main 1(DE)

(54) High temperature superconductor materials and method for preparation.

(57) High temperature ceramic superconductor compositions with improved current-carrying capacity are prepared by annealing the superconductor material in an atmosphere which comprises a reduced form of the non-metal component of the superconductor phase.

EP 0 374 689 A2

## HIGH TEMPERATURE SUPERCONDUCTOR MATERIALS AND METHOD FOR PREPARATION

This invention relates to ceramic high temperature superconductor materials and to methods for preparing superconductor compositions and articles having enhanced critical current density. In its more particular aspects the invention is directed to unoriented thin films and bulk powders having superconductivity at temperatures above about $30^\circ$ K such as the thallium-calcium-barium-copper oxide and bismuth-calcium-barium-copper oxide systems.

High temperature superconductor materials such as those mentioned above and the yttrium-barium-copper oxide and lanthanum-barium-copper oxide systems are known. Generally, the crystallographic phase responsible for the superconductive capability is described by a formula showing the approximate stoichiometric composition, e.g., $YBa_2Cu_3O_7$ for the well known 1-2-3 compounds.

Although many such materials have been reported to exhibit substantial superconducting properties at temperature above $30^\circ$ K, it has not been possible to provide useful current-carrying capability for forms other than single crystals. Polycrystalline films and sintered powders to not have critical current densities at the operating temperature which are sufficient to be of practical value. To be of practical value a ceramic superconductor must be able to carry or conduct a substantial current, at least approaching current densities of alloy superconductors, at the critical temperature without quenching or loss of superconductivity as evidenced by a substantial increase in electrical resistance.

High critical current densities have been demonstrated for single crystal ceramic superconductors. However, for many applications single crystals are inappropriate and impractical for commercial application. It remains to provide thin films and sinterable bulk powders of ceramic high temperature superconductor compositions which are not only superconductive at temperatures above $30^\circ$ K but are able to carry a substantial current at the critical temperature.

Accordingly, it is an object of this invention to provide ceramic superconductor compositions and articles which are capable of carrying a substantial current at the operating temperature.

Another object of the invention is to provide a method for enhancing the current-carrying capability of ceramic superconductors of polycrystalline thin film and bulk powder origin without chemical modification of the superconductor crystallographic phase.

Another object of the invention is to provide methods for control and modulation of the current carrying capacity of polycrystalline ceramic superconductor compositions.

Another object of the invention is to provide polycrystalline bulk superconducting material comprising one or more superconducting phases of thallium-calcium-barium-copper oxide having substantial current carrying capacity at its operating temperature.

Another object of the invention is to provide an unoriented polycrystalline thallium-containing super-conductor materials having current conducting, i.e., non-insulating grain boundaries.

Another object of the invention is to provide a method for treating unoriented thin films of thallium-containing ceramic copper oxide superconductor to enhance critical current density.

Among the high temperature superconductor material described herein are thallium-calcium-barium-copper oxide compositions, particularly those represented by the formulas: $Tl_2Ba_2Ca_2Cu_2O_{8+y}$ and $Tl_2Ca_2Ba_2Cu_3O_{10+y}$. It is recognized that other superconducting phases of the thallium material have been described and that such phases can coexist. The term "material" as used herein with respect to superconductors is meant to include single and multiphase compositions wherein one or more superconductor phases exist.

Compositions of high temperature thallium-calcium-barium-copper superconductor can be prepared by solid state reaction known in the art. For example, the article by Sheng et al., Physical Review Letters (3/7/88) Volume 60, No. 10, pages 937-940, describes the preparation of compositions of the thallium -barium-copper oxide system and thallium-barium-calcium-copper oxide compositions are described by Sheng et al. in Applied Physics Letters, May 16, 1988, both of which are incorporated herein by reference.

Once prepared, the current carrying capacity of the unoriented polycrystalline material is substantially improved by annealing the material in the presence of thallium or a thallium oxide such as thallous oxide exposing the material at an elevated temperature to an atmosphere comprising thallous oxide for a period of time sufficient to enhance the critical current perhaps by diffusion or precipitation of a current-carrying (non-insulating) specie into or at the grain boundary regions of the polycrystalline matrix.

## DESCRIPTION OF THE INVENTION

The objects of the invention will be achieved by providing ceramic high temperature superconductor polycrystalline compositions which are characterized by non-insulating grain boundaries, i.e, grain boundaries which are capable of carrying sufficient current to approach the current carrying capability of the superconducting phase within the grain. This result will be accomplished by annealing the ceramic superconductor or a stoichiometric admixture of precursor compounds in an atmosphere of a reduced form of an oxide on the metal of the superconductivity promoting cation, e.g., yttrium, thallium, bismuth, strontium, lanthanum, and the like. For example, compositions comprising stoichiometric amounts of the calcium, barium, and copper components will be annealed in the presence of an equilibrium partial pressure of thallous oxide. If desired, the composition may include the requisite amount of thallic oxide to provide the thallium component, optionally with an excess to compensate for loss of thallium by vaporization during sintereing or subsequent annealing.

It will be appreciated that the methods contemplated by this invention include annealing of articles such as thin unoriented films, sintered articles and shapes, and dense powders which have grain boundaries which would be expected to reduce or impede the flow of electrical current from grain to grain. The effect of enhancing critical current density is achieved by providing a conductive grain boundary or its equivalent, e.g., providing intergrain growth or penetration which extends through the grain boundary between adjacent grains.

Ceramic superconductive materials, suitable for the practice of this invention, can be prepared by a variety of techniques, including a solid state reaction, coprecipitation, and salt-gel procedures.

In the solid state reaction technique, one starts with oxygen-rich compounds of the desired components, such as oxides or carbonates. These compounds are generally mixed in the desired atomic ratios and ground to a fine powder to facilitate calcination. These room temperature stable salts are then reacted by calcining for an extended period of time at an elevated temperature. This process may be repeated several times with pulverizing and mixing of the partially calcined material at each step. The process usually ends with a final oxygen anneal followed by a slow cool down to room temperature of the powder or of pellets made from the powder by sintering in a cold or hot press.

The improvement in current carrying capacity or critical current density (Jc) provided by this invention is demonstrated by critical temperature and procedures followed by measurement of the critical current density for the various samples by conventional techniques well known in the art.

An admixture of oxide powders of the appropriate calcium-barium-copper stoichiometry is prepared. The procedures described by Sheng et al., Physical Review Letters, Vol. 60, pages 937-940, can be used. In general, barium carbonate, calcium oxide or carbonate, and copper oxide powders are intimately admixed by grinding and then fired in air for a period of from 24 to 48 hours at 925°C to 950°C with the powder being removed and reground after each 8 hour period of firing.

The powders are then formed into relatively thin sample pellets which will be processed further as follows:

Group I is prepared from the material prepared as above, without admixture of a thallium compound. These pellets are then fired in the presence of thallium oxide to introduce thallium into the composition.

Group II is prepared by admixing the powder with the stoichiometric amount of thallic oxide or a slight excess thereof. The amount of thallic oxide is dependent on the composition of the phase to be prepared. The admixture is then heated in an appropriate container by moving it into the hot zone of a preheated furnace at a temperature which is high enough to form the thallium-containing superconducting phase, e.g., about 900°C for about 5 minutes, after which it is allowed to cool to room temperature over a period of about an hour.

Group III samples are prepared in the same manner as above but are heated in the presence of thallous oxide ($TlO_2$) in an atmosphere which may be oxygen, a mixture of oxygen and nitrogen, or ambient air, for a period of about 30 minutes at 910°C followed by cooling to room temperature over a one hour period. The partial pressure of thallous oxide should correspond to the equillibrium partial pressure of thallous oxide over the thallium-calcium barium-copper oxide phase being formed by the reaction. Cooling of the samples is carried out in the presence of the equilibrium partial pressure of thallous oxide characteristic of the sample as the temperature decreases from the reaction temperature to a point where the partial pressure of thallous oxide becomes insignificant.

## EXPERIMENTAL PROCEDURE

The experimental procedure will focus on the processing of thin pellets of Tl-Ca-Ba-Cu-O high temperature superconductors in an atmosphere containing $Tl_2O$. Several compositions of the thallium based high temperature superconductors will be investigated, e.g., $Tl_2Ca\ Ba_2Cu_2O_{8+y}$, $Tl_2Ca_2Ba_2Cu_3O_{10+y}$, or the like.

The first step will be the preparation of oxide powders of the appropriate Ca-Ba-Cu stoichiometry by methods such as described by A.M. Hermann and Z.Z. Sheng in which $BaCO_3$, $CaO$ or $CaCO_3$, and $CuO$ are intimately mixed by grinding and fired in air for a total of 24 to 48 hours at 925-950°C, with the powder being removed and reground after each eight hours of firing.

Three pellets corresponding to each composition will be prepared. The pellets should be relatively thin, e.g., about 1-2 mm thick. One of the three should be prepared directly from the Ca-Ba-Cu oxide prepared in step one. The second pellet should be prepared from an intimate mixture of the Ca-Ba-Cu oxide with the stoichiometric amount (or slight excess) of $Ti_2O_3$ required by the composition desired. The third pellet in each set should be prepared identically to the second, but additionally, it should be heated in flowing oxygen by placing it in an appropriate container and mixing it into the 900°C hot zone of a preheated furnace and letting it remain there for five minutes before allowing it to cool to room temperature over a one hour period.

The goal of the third step is to heat each of the pellets in the presence of a mixture of 20% oxygen and 80% nitrogen, and $Ti_2O$ vapor at 910°C for 30 minutes followed by cooling to room temperature over a one hour period. The experimental apparatus should be designed in such a manner that the sample is maintained under a partial pressure of thallium oxide ($Tl_2O$) which corresponds to the equilibrium partial pressure of $Tl_2O$ over the Tl-Ca-Ba-Cu-oxide phase being synthesized at the reaction temperature.

## Claims

1. A method for making a high temperature copper oxide ceramic superconductor which comprises annealing a composition comprising calcium carbonate or calcium oxide, barium oxide and copper oxide in the presence of thallous oxide.

2. A method according to claim 1 which comprises annealing a composition comprising calcium carbonate, barium oxide, copper oxide, and thallic oxide in an atmosphere comprising thallous oxide.

3. A method according to claim 1 which comprises annealing stoichiometric amounts of calcium carbonate, barium oxide, copper oxide, and thallic oxide to form a superconductive material having the approximate composition $Tl_2 Ca Ba_2 Cu_2 O_{8+y}$ or $Tl_2 Ca_2 Ba_2 Cu_3 O_{10+y}$.

4. A method according to claim 1 for enhancing the critical current density of thallium or bismuth containing a ceramic copper oxide superconductor which comprises annealing the superconductor composition in the presence of a thallium or bismuth compound which will diffuse into or cause formation of a non-insulating material at grain boundaries of the ceramic.

5. A method according to claim 1 for increasing the critical current density of a high temperature superconductor which comprises annealing the superconductor composition in the presence of a reduced oxide compound of the non-metal component of the composition.

6. A method according to claim 1 which comprises annealing a stoichiometric admixture comprising calcium oxide or calcium carbonate, barium carbonate, and copper oxide in a sealed reaction chamber containing an equilibrium partial pressure of thallous oxide.

7. A high temperature ceramic superconductor composition having non-insulating grain boundaries.

8. A composition according to claim 7 which comprises a superconductive phase of the thallium-calcium-barium-copper oxide system having non-insulating grain boundaries.

9. A composition according to claim 7 in the form of an unoriented polycrystalline thin film.

10. A composition according to claim 7 in the form of a sintered polycrystalline shape.

11. A high temperature ceramic superconductor composition of the thallium-calcium-barium-copper oxide system, according to claim 7, having a current-carrying phase within its grain boundaries.